# EUROPEAN PATENT APPLICATION

(11) **EP 4 621 581 A1**
(43) Date of publication of application: **24.09.2025**
(21) Application number: 25164046.2
(22) Date of filing: 17.03.2025
(51) Int. Cl.: G06F 13/16, G11C 5/02, G11C 7/10, G06N 3/063

(54) **SYSTEMS AND METHODS OF INCORPORATING ARTIFICIAL INTELLIGENCE ACCELERATORS ON MEMORY BASE DIES**

(30) Priority: 21.03.2024 US 202463568411 P; 28.06.2024 US 202463666105 P; 27.01.2025 US 202519038672
(71) Applicant: Samsung Electronics Co., Ltd., Suwon-si, Gyeonggi-do 16677 (KR)
(72) Inventor: JEONG, Hyoun Kwon, San Jose, CA, 95134 (US); JEONG, Soogil, San Jose, CA, 95134 (US)
(74) Representative: Kuhnen & Wacker Patent- und Rechtsanwaltsbüro PartG mbB

(57) **Abstract**

Provided are systems, methods, and apparatuses for incorporating artificial intelligence (AI) accelerators on memory base dies. In one or more examples, the systems, devices, and methods include determining at least one feature of a data query; routing, based on the at least one feature of the data query, a first function of the data query to a memory base die for processing by a processing unit on the memory base die; and processing, via the processing unit, data that a memory controller on the memory base die receives from at least one of one or more memory dies stacked on top of the memory base die.

## Description

### CROSS-REFERENCE TO RELATED APPLICATIONS

### TECHNICAL FIELD

The disclosure relates generally to memory systems. In particular, the subject matter relates to incorporating artificial intelligence (AI) accelerators on memory base dies.

### BACKGROUND

The present background section is intended to provide context only, and the disclosure of any concept in this section does not constitute an admission that said concept is prior art.

AI workloads demand memory and storage solutions that provide high throughput and low latency to accommodate rapid processing of relatively large datasets. High throughput memory/storage ensures data can be read and written quickly. Low latency memory/storage provides quick data access for real-time AI applications. However, the proliferation of AI has resulted in a rapid increase in demands for improvements in data movement bandwidths and data storage capacity, which has left data centers and related devices struggling to keep up with demand.

### SUMMARY

In various embodiments, the systems and methods described herein include systems, methods, and apparatuses for incorporating AI accelerators on memory base dies (e.g., base dies of high-bandwidth memory). In some aspects, the techniques described herein relate to a method of processing in a memory, the method including: determining at least one feature of a data query; routing, based on the at least one feature of the data query, a first function of the data query to a memory base die for processing by a processing unit on the memory base die; and processing, via the processing unit, data that a memory controller on the memory base die receives from at least one of one or more memory dies stacked on top of the memory base die.

In some aspects, the techniques described herein relate to a method, further including routing the first function to the memory base die for processing by the processing unit on the memory base die based on a determination that the first function is a memory bound function.

In some aspects, the techniques described herein relate to a method, further including routing a second function of the data query to a compute die for processing by the compute die based on a determination that the second function is a compute bound operation, wherein the compute die is connected to the memory base die via a silicon interposer of a system in package that includes the compute die and the memory base die.

In some aspects, the techniques described herein relate to a method, wherein the memory base die includes a memory expansion port connected to at least one of a low power double data rate memory or a graphics double data rate memory external to the memory base die.

In some aspects, the techniques described herein relate to a method, further including at least one of: routing, via the memory controller, functions of a first category to the memory base die for processing by the processing unit on the memory base die, routing, via the memory controller, functions of a second category to a compute die for processing by the compute die, or routing, via the memory controller, functions of a third category to at least one of the low power double data rate memory or the graphics double data rate memory external to the memory base die.

In some aspects, the techniques described herein relate to a method, further including: transferring, by way of a through silicon via, the data from the one or more memory dies to a physical layer interface of the memory base die; transferring the data from the physical layer interface to the memory controller of the memory base die; and transferring the data from the memory controller to a shared memory on the memory base die, wherein the shared memory holds the data for processing of the data by the processing unit.

In some aspects, the techniques described herein relate to a method, wherein the processing unit includes at least one of: a tensor core configured for matrix multiplication, or an accumulator configured for accumulating intermediate calculations.

In some aspects, the techniques described herein relate to a method, wherein: the memory controller connects to the processing unit via a network on chip (NOC) interconnect bus, and the memory controller connects to a dynamic random-access memory (DRAM) physical layer on the memory base die via a double data rate (DDR) physical layer interface of the memory base die.

In some aspects, the techniques described herein relate to a method, wherein: a system bus interface connects to a die-to-die interface of the memory base die, and the processing unit connects to the system bus interface via the NOC interconnect bus, the system bus interface converting data in a die-to-die flit format to a network packet format.

In some aspects, the techniques described herein relate to a method, wherein: the memory controller is communicatively coupled to the processing unit, and a second memory controller on the memory base die is communicatively coupled to a second processing unit on the memory base die.

In some aspects, the techniques described herein relate to a system including: a memory base die, the memory base die including: a memory controller; one or more memory dies stacked on top of the memory base die; and a processing unit configured to process data that the memory controller receives from at least one of the one or more memory dies, the data being routed to the processing unit based on at least one feature of a data query associated with the data; an interconnect that connects the memory controller to the one or more memory dies stacked on the memory base die and to multiple processing units that include the processing unit; and a die-to-die interface that connects the memory base die to a compute die of a system in package.

In some aspects, the techniques described herein relate to a system, wherein a function of the data query is routed to the memory base die for processing by the processing unit based on a determination that the function is a memory bound function.

In some aspects, the techniques described herein relate to a system, wherein a function of a second data query is routed to the compute die for processing by the compute die based on a determination that the second function is a compute bound operation, wherein the compute die is connected to the memory base die via a silicon interposer of the system in package.

In some aspects, the techniques described herein relate to a system, wherein the system in package includes multiple memory base dies connected to the compute die, the multiple memory base dies including the memory base die.

In some aspects, the techniques described herein relate to a system, wherein: the memory base die includes a system bus interface that connects the interconnect to the die-to-die interface of the memory base die, and the system bus interface maps a data format used by the interconnect to a data format used by the die-to-die interface.

In some aspects, the techniques described herein relate to a system, wherein the memory base die includes a shared memory to share data between a first processing unit and a second processing unit of the multiple processing units.

In some aspects, the techniques described herein relate to a system, wherein the memory base die includes a memory expansion port connected to at least one of a low power double data rate memory or a graphics double data rate memory external to the memory base die.

In some aspects, the techniques described herein relate to a non-transitory computer-readable medium storing code that includes instructions executable by a processor of a device to: determine at least one feature of a data query; route, based on the at least one feature of the data query, a first function of the data query to a memory base die for processing by a processing unit on the memory base die; and process, via the processing unit, data that a memory controller on the memory base die receives from at least one of one or more memory dies stacked on top of the memory base die.

In some aspects, the techniques described herein relate to a non-transitory computer-readable medium, wherein the code includes further instructions executable by the processor to route the first function to the memory base die for processing by the processing unit on the memory base die based on a determination that the first function is a memory bound function.

In some aspects, the techniques described herein relate to a non-transitory computer-readable medium, wherein the code includes further instructions executable by the processor to route a second function of the data query to a compute die for processing by the compute die based on a determination that the second function is a compute bound operation, wherein the compute die is connected to the memory base die via a silicon interposer of a system in package that includes the compute die and the memory base die.

A computer-readable medium is disclosed. The computer-readable medium can store instructions that, when executed by a computer, cause the computer to perform substantially the same or similar operations as described herein are further disclosed. Similarly, non-transitory computer-readable media, devices, and systems for performing substantially the same or similar operations as described herein are further disclosed.

The techniques of AI accelerators on high-bandwidth memory (HBM) dies described herein include multiple advantages and benefits. For example, combining AI accelerators on HBM dies provides increased data bandwidth, allowing faster data transfers between the memory and the AI accelerators. Faster data transfers between the AI accelerators and HBM memory results in quicker system performance, faster processing times, improved AI response times (e.g., quicker query response times), lower power consumption, and increased power efficiency.

### ADVANTAGEOUS EFFECT OF THE INVENTRION

According to the present invention, an AI accelerator can be coupled to the HBM die. Accordingly, the data bandwidth of the storage device can be increased to enable faster data transfer between the memory and the AI accelerator.

Thus, systems and methods are provided for integrating AI accelerators into memory base dies with improved performance.

### BRIEF DESCRIPTION OF THE DRAWINGS

The above-mentioned aspects and other aspects of the present systems and methods will be better understood when the present application is read in view of the following figures in which like numbers indicate similar or identical elements. Further, the drawings provided herein are for purpose of illustrating certain embodiments only; other embodiments, which may not be explicitly illustrated, are not excluded from the scope of this disclosure.

These and other features and advantages of the present disclosure will be appreciated and understood with reference to the specification, claims, and appended drawings, wherein:
FIG. 1 illustrates an example system in accordance with one or more implementations as described herein.
FIG. 2 illustrates details of the system of FIG. 1, according to one or more implementations as described herein.
FIG. 3 illustrates an example base die in accordance with one or more implementations as described herein.
FIG. 4 illustrates an example package in accordance with one or more implementations as described herein.
FIG. 5 illustrates an example base die in accordance with one or more implementations as described herein.
FIG. 6 depicts a flow diagram illustrating an example method associated with the disclosed systems, in accordance with example implementations described herein.
FIG. 7 depicts a flow diagram illustrating an example method associated with the disclosed systems, in accordance with example implementations described herein.
FIG. 8 depicts a flow diagram illustrating an example method associated with the disclosed systems, in accordance with example implementations described herein.
FIG. 9 depicts a flow diagram illustrating an example method associated with the disclosed systems, in accordance with example implementations described herein.

While the present systems and methods are susceptible to various modifications and alternative forms, specific embodiments thereof are shown by way of example in the drawings and will herein be described. The drawings may not be to scale. It should be understood, however, that the drawings and detailed description thereto are not intended to limit the present systems and methods to the particular form disclosed, but to the contrary, the intention is to cover all modifications, equivalents, and alternatives falling within the spirit and scope of the present systems and methods as defined by the appended claims.

### DETAILED DESCRIPTION OF VARIOUS EMBODIMENTS

The details of one or more embodiments of the subject matter described herein are set forth in the accompanying drawings and the description below. Other features, aspects, and advantages of the subject matter will become apparent from the description, the drawings, and the claims.

Various embodiments of the present disclosure now will be described more fully hereinafter with reference to the accompanying drawings, in which some, but not all embodiments are shown. Indeed, the disclosure may be embodied in many forms and should not be construed as limited to the embodiments set forth herein; rather, these embodiments are provided so that this disclosure will satisfy applicable legal requirements. The term "or" is used herein in both the alternative and conjunctive sense, unless otherwise indicated. The terms "illustrative" and "example" are used to be examples with no indication of quality level. Like numbers refer to like elements throughout. Arrows in each of the figures depict bi-directional data flow and/or bi-directional data flow capabilities. The terms "path," "pathway" and "route" are used interchangeably herein.

Embodiments of the present disclosure may be implemented in various ways, including as computer program products that comprise articles of manufacture. A computer program product may include a non-transitory computer-readable storage medium storing applications, programs, program components, scripts, source code, program code, object code, byte code, compiled code, interpreted code, machine code, executable instructions, and/or the like (also referred to herein as executable instructions, instructions for execution, computer program products, program code, and/or similar terms used herein interchangeably). Such non-transitory computer-readable storage media include all computer-readable media (including volatile and non-volatile media).

In one embodiment, a non-volatile computer-readable storage medium may include a floppy disk, flexible disk, hard disk, solid-state storage (SSS) (for example a solid-state drive (SSD)), solid state card (SSC), solid state module (SSM), enterprise flash drive, magnetic tape, or any other non-transitory magnetic medium, and/or the like. A non-volatile computer-readable storage medium may include a punch card, paper tape, optical mark sheet (or any other physical medium with patterns of holes or other optically recognizable indicia), compact disc read only memory (CD-ROM), compact disc-rewritable (CD-RW), digital versatile disc (DVD), Blu-ray disc (BD), any other non-transitory optical medium, and/or the like. Such a non-volatile computer-readable storage medium may include read-only memory (ROM), programmable read-only memory (PROM), erasable programmable read-only memory (EPROM), electrically erasable programmable read-only memory (EEPROM), flash memory (for example Serial, NAND, NOR, and/or the like), multimedia memory cards (MMC), secure digital (SD) memory cards, SmartMedia cards, CompactFlash (CF) cards, Memory Sticks, and/or the like. Further, a non-volatile computer-readable storage medium may include conductive-bridging random access memory (CBRAM), phase-change random access memory (PRAM), ferroelectric random-access memory (FeRAM), non-volatile random-access memory (NVRAM), magnetoresistive random-access memory (MRAM), resistive random-access memory (RRAM), Silicon-Oxide-Nitride-Oxide-Silicon memory (SONOS), floating junction gate random access memory (FJG RAM), Millipede memory, racetrack memory, and/or the like.

In one embodiment, a volatile computer-readable storage medium may include random access memory (RAM), dynamic random access memory (DRAM), static random access memory (SRAM), fast page mode dynamic random access memory (FPM DRAM), extended data-out dynamic random access memory (EDO DRAM), synchronous dynamic random access memory (SDRAM), double data rate synchronous dynamic random access memory (DDR SDRAM), double data rate type two synchronous dynamic random access memory (DDR2 SDRAM), low power DDR (LPDDR), graphic DDR (GDDR), double data rate type three synchronous dynamic random access memory (DDR3 SDRAM), Rambus dynamic random access memory (RDRAM), Twin Transistor RAM (TTRAM), Thyristor RAM (T-RAM), Zero-capacitor (Z-RAM), Rambus in-line memory component (RIMM), dual in-line memory component (DIMM), single in-line memory component (SIMM), video random access memory (VRAM), cache memory (including various levels), flash memory, register memory, and/or the like. It will be appreciated that where embodiments are described to use a computer-readable storage medium, other types of computer-readable storage media may be substituted for or used in addition to the computer-readable storage media described above.

As should be appreciated, various embodiments of the present disclosure may be implemented as methods, apparatus, systems, computing devices, computing entities, and/or the like. As such, embodiments of the present disclosure may take the form of an apparatus, system, computing device, computing entity, and/or the like executing instructions stored on a computer-readable storage medium to perform certain steps or operations. Thus, embodiments of the present disclosure may take the form of a hardware embodiment, a computer program product embodiment, and/or an embodiment that comprises a combination of computer program products and hardware performing certain steps or operations.

Embodiments of the present disclosure are described below with reference to block diagrams and flowchart illustrations. Thus, it should be understood that each block of the block diagrams and flowchart illustrations may be implemented in the form of a computer program product, a hardware embodiment, a combination of hardware and computer program products, and/or apparatus, systems, computing devices, computing entities, and/or the like carrying out instructions, operations, steps, and similar words used interchangeably (for example the executable instructions, instructions for execution, program code, and/or the like) on a computer-readable storage medium for execution. For example, retrieval, loading, and execution of code may be performed sequentially, such that one instruction is retrieved, loaded, and executed at a time. In some example embodiments, retrieval, loading, and/or execution may be performed in parallel, such that multiple instructions are retrieved, loaded, and/or executed together. Thus, such embodiments can produce specifically configured machines performing the steps or operations specified in the block diagrams and flowchart illustrations. Accordingly, the block diagrams and flowchart illustrations support various combinations of embodiments for performing the specified instructions, operations, or steps.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not be necessarily all referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "predetermined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. Similarly, various waveforms and timing diagrams are shown for illustrative purpose only. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on chip (SoC), an assembly, and so forth.

The following description is presented to enable one of ordinary skill in the art to make and use the subject matter disclosed herein and to incorporate it in the context of particular applications. While the following is directed to specific examples, other and further examples may be devised without departing from the basic scope thereof.

Various modifications, as well as a variety of uses in different applications, will be readily apparent to those skilled in the art, and the general principles defined herein may be applied to a wide range of embodiments. Thus, the subject matter disclosed herein is not intended to be limited to the embodiments presented, but is to be accorded the widest scope consistent with the principles and novel features disclosed herein.

In the description provided, numerous specific details are set forth in order to provide a more thorough understanding of the subject matter disclosed herein. It will, however, be apparent to one skilled in the art that the subject matter disclosed herein may be practiced without necessarily being limited to these specific details. In other instances, well-known structures and devices are shown in block diagram form, rather than in detail, in order to avoid obscuring the subject matter disclosed herein.

All the features disclosed in this specification (e.g., any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Various features are described herein with reference to the figures. It should be noted that the figures are only intended to facilitate the description of the features. The various features described are not intended as an exhaustive description of the subject matter disclosed herein or as a limitation on the scope of the subject matter disclosed herein. Additionally, an illustrated example need not have all the aspects or advantages shown. An aspect or an advantage described in conjunction with a particular example is not necessarily limited to that example and can be practiced in any other examples even if not so illustrated, or if not so explicitly described.

It is noted that, if used, the labels left, right, front, back, top, bottom, forward, reverse, clockwise and counterclockwise have been used for convenience purposes only and are not intended to imply any particular fixed direction. Instead, the labels are used to reflect relative locations and/or directions between various portions of an object.

Any data processing may include data buffering, aligning incoming data from multiple communication lanes, forward error correction ("FEC"), and/or others. For example, data may be first received by an analog front end (AFE), which prepares the incoming for digital processing. The digital portion (e.g., DSPs) of the transceivers may provide skew management, equalization, reflection cancellation, and/or other functions. It is to be appreciated that the process described herein can provide many benefits, including saving both power and cost.

Moreover, the terms "system," "component," "module," "interface," "model," or the like are generally intended to refer to a computer-related entity, either hardware, a combination of hardware and software, software, or software in execution. For example, a component may be, but is not limited to being, a process running on a processor, a processor, an object, an executable, a thread of execution, a program, and/or a computer. By way of illustration, both an application running on a controller and the controller can be a component. One or more components may reside within a process and/or thread of execution and a component may be localized on one computer and/or distributed between two or more computers.

Unless explicitly stated otherwise, each numerical value and range may be interpreted as being approximate, as if the word "about" or "approximately" preceded the value of the value or range. Signals and corresponding nodes or ports might be referred to by the same name and are interchangeable for purposes here.

While embodiments may have been described with respect to circuit functions, the embodiments of the subject matter disclosed herein are not limited. Possible implementations may be embodied in a single integrated circuit, a multi-chip module, a single card, system-on-a-chip, or a multi-card circuit pack. As would be apparent to one skilled in the art, the various embodiments might also be implemented as part of a larger system. Such embodiments may be employed in conjunction with, for example, a digital signal processor, microcontroller, field-programmable gate array, application-specific integrated circuit, or general-purpose computer.

As would be apparent to one skilled in the art, various functions of circuit elements may also be implemented as processing blocks in a software program. Such software may be employed in, for example, a digital signal processor, microcontroller, or general-purpose computer. Such software may be embodied in the form of program code embodied in tangible media, such as magnetic recording media, optical recording media, solid-state memory, floppy diskettes, CD-ROMs, hard drives, or any other non-transitory machine-readable storage medium, that when the program code is loaded into and executed by a machine, such as a computer, the machine becomes an apparatus for practicing the subject matter disclosed herein. When implemented on a general-purpose processor, the program code segments combine with the processor to provide a unique device that operates analogously to specific logic circuits. Described embodiments may also be manifest in the form of a bit stream or other sequence of signal values electrically or optically transmitted through a medium, stored magnetic-field variations in a magnetic recording medium, etc., generated using a method and/or an apparatus as described herein.

The system costs and power consumption of large language model (LLM) inferencing systems are increasing at a rapid rate. The relatively high system costs and power consumption may result in the Generative Pre-Trained Transformer (GPT) AI model being unsustainable. Compute node chips are increasing in size to accommodate the compute power and memory bandwidth demands of LLMs. However, compute die sizes may be limited based on reticle size limits (e.g., limited to 33 millimeters (mm) x 26 mm). The reticle size physical limit can limit the amount of compute resources may be added to a given compute die.

The systems and methods described may include and/or may be based on incorporating processing units (e.g., AI accelerators) on base dies of stacked memory modules (e.g., layers of DRAM stacked on HBM base dies), providing an efficient way to increase compute resources in memory systems without increasing compute die size. As a result, the systems and methods increase the energy efficiency, lower system costs, and lower power consumption of AI compute systems.

Incorporating AI accelerators on base dies of stacked memory modules provides enhanced data latency between compute node and memory. Also, incorporating AI accelerators on HBM dies also reduces power consumption by eliminating data movement from an HBM die to a compute die via an interposer (e.g., silicon interposer, redistribution layer (RDL) interposer, organic interposer). Also, faster data transfers between the AI accelerators and HBM memory results in quicker system performance, faster processing times, and improved AI response times (e.g., quicker query response times). System in Packages (SiPs) in high performance graphics processing unit (GPU) / tensor processing unit (TPU) systems may integrate both compute dies and multiple HBM dies on an interposer. The systems and methods described increase computation power and lower costs of SiP packages.

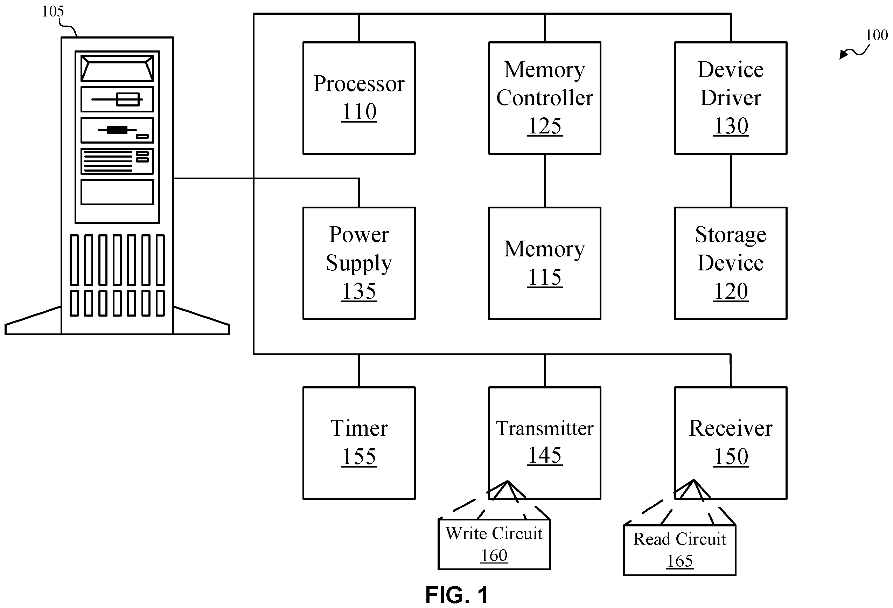

**FIG. 1** illustrates an example system 100 in accordance with one or more implementations as described herein. In FIG. 1, machine 105, which may be termed a host, a system, or a server, is shown. While FIG. 1 depicts machine 105 as a tower computer, embodiments of the disclosure may extend to any form factor or type of machine. For example, machine 105 may be a rack server, a blade server, a desktop computer, a tower computer, a mini tower computer, a desktop server, a laptop computer, a notebook computer, a tablet computer, etc.

Machine 105 may include processor 110, memory 115, and storage device 120. Processor 110 may be any variety of processor. It is noted that processor 110, along with the other components discussed below, are shown outside the machine for ease of illustration: embodiments of the disclosure may include these components within the machine. While FIG. 1 shows a single processor 110, machine 105 may include any number of processors, each of which may be single core or multi-core processors, each of which may implement a Reduced Instruction Set Computer (RISC) architecture or a Complex Instruction Set Computer (CISC) architecture (among other possibilities), and may be mixed in any desired combination. In some examples, machine 105 may include or may be part of a fabrication system for fabricating memory die components, incorporating processing units on memory base dies, fabricating compute dies and stacked memory dies in a package, etc.

Processor 110 may be coupled to memory 115. Memory 115 may be any variety of memory, such as flash memory, Dynamic Random Access Memory (DRAM), Static Random Access Memory (SRAM), Persistent Random Access Memory, Ferroelectric Random Access Memory (FRAM), or Non-Volatile Random Access Memory (NVRAM), such as Magnetoresistive Random Access Memory (MRAM), Phase Change Memory (PCM), or Resistive Random-Access Memory (ReRAM). Memory 115 may include volatile and/or non-volatile memory. Memory 115 may use any desired form factor: for example, Single In-Line Memory Module (SIMM), Dual In-Line Memory Module (DIMM), Non-Volatile DIMM (NVDIMM), etc. Memory 115 may be any desired combination of different memory types, and may be managed by memory controller 125. Memory 115 may be used to store data that may be termed "short-term": that is, data not expected to be stored for extended periods of time. Examples of short-term data may include temporary files, data being used locally by applications (which may have been copied from other storage locations), and the like.

Processor 110 and memory 115 may support an operating system under which various applications may be running. These applications may issue requests (which may be termed commands) to read data from or write data to either memory 115 or storage device 120. When storage device 120 is used to support applications reading or writing data via some sort of file system, storage device 120 may be accessed using device driver 130. While FIG. 1 shows one storage device 120, there may be any number (one or more) of storage devices in machine 105. Storage device 120 may support any desired protocol or protocols, including, for example, the Non-Volatile Memory Express (NVMe^{®}) protocol, a Serial Attached Small Computer System Interface (SCSI) (SAS) protocol, or a Serial AT Attachment (SATA) protocol. Storage device 120 may include any desired interface, including, for example, a Peripheral Component Interconnect Express (PCIe^{®}) interface, or a Compute Express Link (CXL^{®}) interface. Storage device 120 may take any desired form factor, including, for example, a U.2 form factor, a U.3 form factor, a M.2 form factor, Enterprise and Data Center Standard Form Factor (EDSFF) (including all of its varieties, such as E1 short, E1 long, and the E3 varieties), or an Add-In Card (AIC).

While FIG. 1 uses the term "storage device," embodiments of the disclosure may include any storage device formats that may benefit from the use of computational storage units, examples of which may include hard disk drives, Solid State Drives (SSDs), or persistent memory devices, such as PCM, ReRAM, or MRAM. Any reference to "storage device" "SSD" below should be understood to include such other embodiments of the disclosure and other varieties of storage devices. In some cases, the term "storage unit" may encompass storage device 120 and memory 115. Machine 105 may include power supply 135. Power supply 135 may provide power to machine 105 and its components.

Machine 105 may include transmitter 145 and receiver 150. Transmitter 145 or receiver 150 may be respectively used to transmit or receive data. In some cases, transmitter 145 and/or receiver 150 may be used to communicate with memory 115 and/or storage device 120. Transmitter 145 may include write circuit 160, which may be used to write data into storage, such as a register, in memory 115 and/or storage device 120. In a similar manner, receiver 150 may include read circuit 165, which may be used to read data from storage, such as a register, from memory 115 and/or storage device 120. In the illustrated example, machine 105 may include timer 155, which may be used to time one or more operations, indicate a time period, indicate a lapse of time, indicate an expiration, indicate a timeout, etc.

In one or more examples, machine 105 may be implemented with any type of apparatus. Machine 105 may be configured as (e.g., as a host of) one or more servers such as a compute server, a storage server, storage node, a network server, a supercomputer, data center system, and/or the like, or any combination thereof. Additionally, or alternatively, machine 105 may be configured as (e.g., as a host of) one or more computers such as a workstation, a personal computer, a tablet, a smartphone, and/or the like, or any combination thereof. Machine 105 may be implemented with any type of apparatus that may be configured as a device including, for example, an accelerator device, a storage device, a network device, a memory expansion and/or buffer device, a central processing unit (CPU), a graphics processing unit (GPU), a neural processing unit (NPU), a tensor processing unit (TPU), intelligent processing unit (IPU), optical processing units (OPU), and/or the like, or any combination thereof.

Any communication between devices including machine 105 (e.g., host, computational storage device, and/or any intermediary device) can occur over an interface that may be implemented with any type of wired and/or wireless communication medium, interface, protocol, and/or the like including PCIe, NVMe, Ethernet, NVMe-oF, Compute Express Link (CXL), and/or a coherent protocol such as CXL.mem, CXL.cache, CXL.IO and/or the like, Gen-Z, Open Coherent Accelerator Processor Interface (OpenCAPI), Cache Coherent Interconnect for Accelerators (CCIX), Advanced eXtensible Interface (AXI), coherent hub interface (CHI), and/or the like, or any combination thereof, Transmission Control Protocol/Internet Protocol (TCP/IP), FibreChannel, InfiniBand, Serial AT Attachment (SATA), Small Computer Systems Interface (SCSI), Serial Attached SCSI (SAS), iWARP, any generation of wireless network including 2G, 3G, 4G, 5G, and/or the like, any generation of Wi-Fi, Bluetooth, near-field communication (NFC), and/or the like, or any combination thereof. In some embodiments, the communication interfaces may include a communication fabric including one or more links, buses, switches, hubs, nodes, routers, translators, repeaters, and/or the like. In some embodiments, system 100 may include one or more additional apparatus having one or more additional communication interfaces.

Any of the functionality described herein, including any of the host functionality, device functionally, and/or the like, may be implemented with hardware, software, firmware, or any combination thereof including, for example, hardware and/or software combinational logic, sequential logic, timers, counters, registers, state machines, volatile memories such as at least one of or any combination of the following: dynamic random access memory (DRAM) and/or static random access memory (SRAM), nonvolatile memory including flash memory, persistent memory such as cross-gridded nonvolatile memory, memory with bulk resistance change, phase change memory (PCM), and/or the like and/or any combination thereof, complex programmable logic devices (CPLDs), field programmable gate arrays (FPGAs), application specific integrated circuits (ASICs) CPUs including complex instruction set computer (CISC) processors such as x86 processors and/or reduced instruction set computer (RISC) processors such as RISC-V and/or ARM processors), GPUs, NPUs, TPUs, IPUs, OPUs, and the like, executing instructions stored in any type of memory.

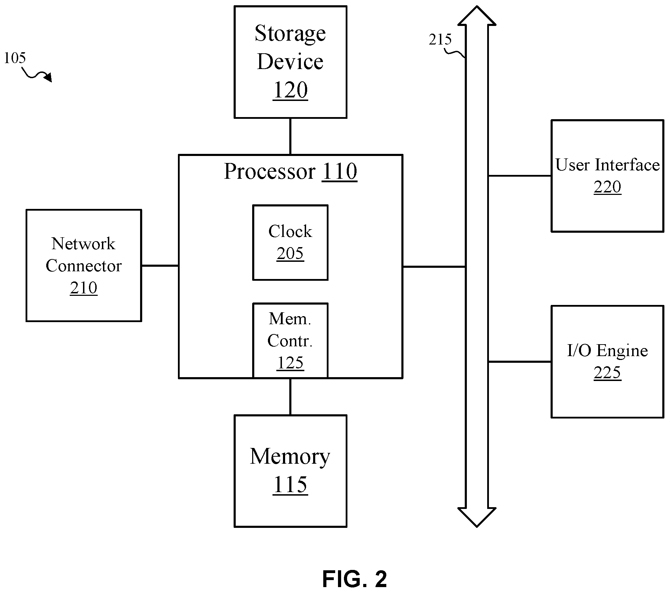

**FIG. 2** illustrates details of machine 105 of FIG. 1, according to examples described herein. In the illustrated example, machine 105 may include processor 110. Processor 110 may include one or more processors and/or one or more dies. Processor 110 may include memory controller 125 (e.g., one or more memory controllers) and clock 205 (e.g. one or more clocks), which may be used to coordinate the operations of the components of the machine. Processor 110 may be coupled to memory 115 (e.g., one or more memory chips, stacked memory, etc.), which may include random access memory (RAM), read-only memory (ROM), or other state preserving media, as examples. Processor 110 may be coupled to storage device 120 (e.g., one or more storage devices), and to network connector 210, which may be, for example, an Ethernet connector or a wireless connector. Processor 110 may be connected to bus 215 (e.g., one or more buses), to which may be attached user interface 220 (e.g., one or more user interfaces) and Input/Output (I/O) interface ports that may be managed using I/O engine 225 (e.g., one or more I/O engines), among other components.

The systems and methods described herein include logic to provide AI accelerators on HBM dies. The logic includes any combination of hardware (e.g., at least one memory, at least one processor), logical circuitry, firmware, and/or software to provide and/or implement AI accelerators on HBM dies.

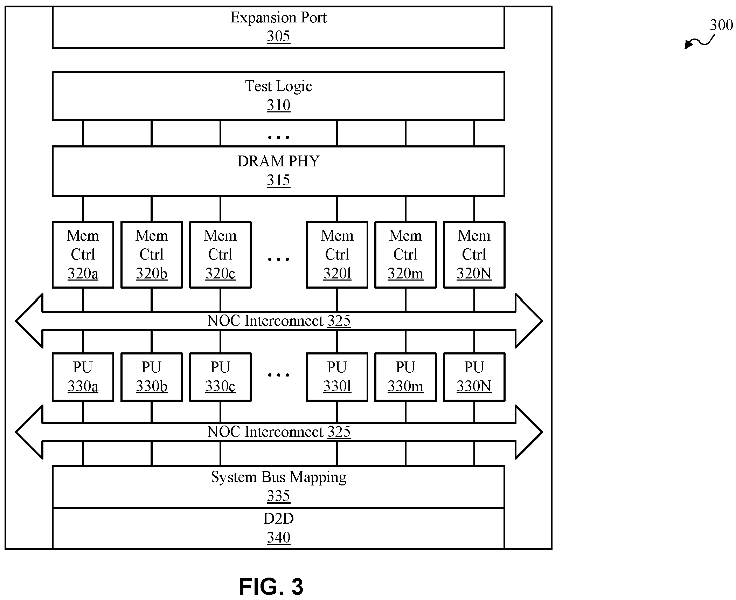

**FIG. 3** illustrates an example base die 300 in accordance with one or more implementations as described herein. In some configurations, one or more aspects of base die 300 may be implemented by or in conjunction with machine 105, components of machine 105, or any combination thereof. In some examples, base die 300 may be a base layer of a stacked memory module (e.g., HBM memory module, HBM chip). In some cases, base die 300 may be part of an SoC. 2.5D and/or 3D stacking technology may be used to stack memory chips on base die 300.

In some cases, base die 300 may be referred to as a buffer die or logic die. Base die 300 may include the bottom layer of an HBM stack (e.g., bottom layer of an HBM module). Base die 300 may control one or more aspects of a stacked memory module. In some cases, base die 300 may be part of a System-on-Chip (SoC). SoCs can include a processor, memory, input/output interfaces, etc. SoCs may include analog, digital, mixed signal and other radio frequency functions, all lying on a single chip substrate. In some cases, base die 300 may be part of a system in package (SiP), which may include two or more dies containing integrated circuits stacked vertically on a package substrate.

In the illustrated example, base die 300 may include expansion port 305, test logic 310, DRAM physical layer (PHY) 315, at least one memory controller (e.g., N memory controllers 320, where N is a positive integer such as 1, 2, 3, 4, 5, 6, 8, 10, 12, 16, 20, 32, etc.), network on chip (NOC) interconnect 325, at least one processing unit (PU) (e.g., N PUs 330), system bus interface 335 (e.g., system bus mapping interface), and die-to-die (D2D) 340. As shown, base die 300 may include one or more connection interfaces (e.g., expansion port 305, D2D 340).

In some examples, expansion port 305 may provide D2D-based memory expansion. In some cases, expansion port 305 may provide expansion options for adding additional memory to a given system (e.g., additional memory for processing LLMs, etc.). In some examples, expansion port 305 may connect to one or more memories external to base die 300 (e.g., off-die memories). In some cases, expansion port 305 may include a D2D interface separate from D2D 340. In some cases, expansion port 305 may expand memory available for processing (e.g., AI processing). In some cases, a first process may be executed on base die 300 via the N PUs 330. Additionally, or alternatively, a second process may be executed in conjunction with a processor and a memory external to base die 300, but connected to base die 300 via expansion port 305. Additionally, or alternatively, a third process may be executed by a compute die that is communicatively connected to base die 300 (e.g., via D2D 340). Base die 300 may include expansion port 305 based on memory capacity and memory costs. Expansion port 305 may expand the memory capacity of base die 300 by connecting base die 300 to memory external to base die 300. Some types of memory may have a lower cost than other types of memory. For example, LPDDR and GDDR may be slower than HBM, but their capacity is typically larger than HBM based on the lower cost of LPDDR and GDDR. Accordingly, expansion port 305 may connect base die 300 to off-die memory (e.g., LPDDR, GDDR, etc.).

Test logic 310 may provide testing on base die 300. In some cases, test logic 310 may include Built-In Self-Test (BIST), which may enable base die 300 to test components of base die 300 without the need for external test equipment. In some cases, test logic 310 may generate and apply test patterns to a component of base die 300, execute the tests, and analyze the results to determine whether the component is operated as expected or if testing indicates an anomaly. In some cases, one or more aspects of test logic 310 may be based on Institute of Electrical and Electronics Engineers (IEEE) 1500, which may include a standard that defines how to test the design and/or operation of base die 300.

DRAM PHY 315 may be based on and/or may include a physical layer (PHY). A PHY can include an electronic circuit that connects a network interface controller to a physical medium (e.g., copper connection, optical fiber). A PHY may be responsible for the physical layer functions of the Open Systems Interconnection (OSI) model. In some cases, a DDR memory system (e.g., that includes base die 300) may include a DDR memory controller and a DDR PHY (e.g., DDR PHY 315) to access DDR memory. DDR PHY 315 may include a DDR PHY Interface (DFI), which may be based on an interface protocol that defines signals, timing, and programmable parameters used to transfer control information and/or data between a memory controller (e.g., at least one memory controller 320) and a PHY (e.g., DDR PHY 315). In the illustrated example, an N-channel (e.g., 32-bit channel) DFI-based interface may connect DRAM PHY 315 to the N memory controllers 320. In some cases, DRAM PHY 315 may include or may be connected to a through silicon via (TSV) landing zone. The TSV landing zone may include an area dedicated to TSV connections that connect base die 300 to layers of core memory dies stacked on top of base die 300.

In some examples, the N memory controllers 320 may control one or more aspects of memory associated with base die 300. For example, one or more core memory dies may be stacked on top of base die 300. The N memory controllers 320 may control one or more aspects of the one or more core memory dies stacked on top of base die 300. The N memory controllers 320 may be configured to act as a bridge between a processor (e.g., N PUs 330) and memory (e.g., the one or more core memory dies stacked on top of base die 300). The N memory controllers 320 may manage the flow of data between memory / processor, handle read and write operations associated with the memory of base die 300 and the N PUs 330, manage data integrity, and coordinate memory access, controlling how data is transferred to and from the memory of base die 300 and the N PUs 330.

In some examples, NOC interconnect 325 (e.g., a system level bus) may connect the N memory controllers 320 to the N PUs 330. As shown, NOC interconnect 325 may connect the NPUs 330 to system bus interface 335. In some cases, NOC interconnect may communicate data via packets (e.g., L2 packets).

In some examples, N PUs 330 (e.g., AI accelerators, processor elements (PEs), NPUs, TPUs, GPUs, FPGAs, ASICs, etc.) may be configured to execute tasks on base die 300. The N number of PUs 330 may be based on the amount of available space on base die 300, the size of the PUs, the nanometer process used to manufacture the PUs, etc. In some cases, base die 300 may include one memory controller for each PU. In some cases, base die 300 may include more or less memory controllers than PUs. The systems and methods described herein may be based on and/or may include Processing-in-Memory (PIM) HBM. PIM-HBM can include memory technology that integrates processors into memory (e.g., PUs on base die 300), which can reduce data movement between processors and memory. In some cases, at least one of N PUs 330 may include a tensor core for matrix multiplication, an arithmetic logic unit (ALU) for integer computation, a floating-point unit (FPU) for floating-point computation, and/or an accumulator (e.g., a register to store intermediate logical or arithmetic data for multistep calculations).

Incorporating processing into base die 300 provides increased processing capabilities in HBM memory devices based on a hybrid compute architecture that includes processing from one or more compute dies connected to base die 300 and processing from the N PUs 330 on base die 300. The N PUs 330 may include an AI accelerator (e.g., NPU, GPU, TPU, IPU, etc.). In some cases, N PUs 330 may include tensor cores. Tensor cores can include specialized processing subunits that accelerate AI accelerator performance. Tensor cores can be designed to preserve accuracy while accelerating performance through mixed-precision computing, fused multiply-addition algorithms, matrix multiplication, accumulator functions, etc.

In some examples, system bus interface 335 may interface NOC interconnect 325 to D2D 340. In some cases, system bus interface 335 may map data in a format used by NOC interconnect 325 to a format used by D2D 340; and/or map data in a format used by D2D 340 to a format used by NOC interconnect 325. In some cases, D2D 340 may communicate data based on a flow control unit or flow control digit (flit). A flit can include a link-level atomic element that forms a network packet or stream. A packet may be decomposed into one or more flits, which include a header flit, body flits, and, in some cases, a tail flit. NOC interconnect 325 may communicate data based on packets (e.g., L2 packets). Accordingly, system bus interface 335 may convert a format of a D2D interface (e.g., a flit) to a format of an NOC interconnect (e.g., L2 packet).

In some examples, D2D 340 may be based on universal chiplet interconnect express (UCIe). UCIe can provide die-to-die connectivity in multi-die systems. UCIe can define the physical layer, protocol stack, software model, and procedures for compliance testing. In some cases, D2D 340 may connect base die 300 to a component of a memory system (e.g., of an HBM system). For example, D2D 340 may connect base die 300 to a compute die of the memory system.

Based on the systems and methods described, base die 300 may improve processing times, increase memory bandwidth, and decrease data transfer latencies associated with processing performed on base die 300. Processing on base die 300 may include kernel execution, data movement based on direct memory access (DMA), and AI processing, including activation functions (e.g., Sigmoid-Weighted Linear Unit (SWIGLU), Gaussian Error Linear Units (GELU), Rectified Linear Unit (ReLU), etc.); Softmax calculations; large language models (LLMs), etc.

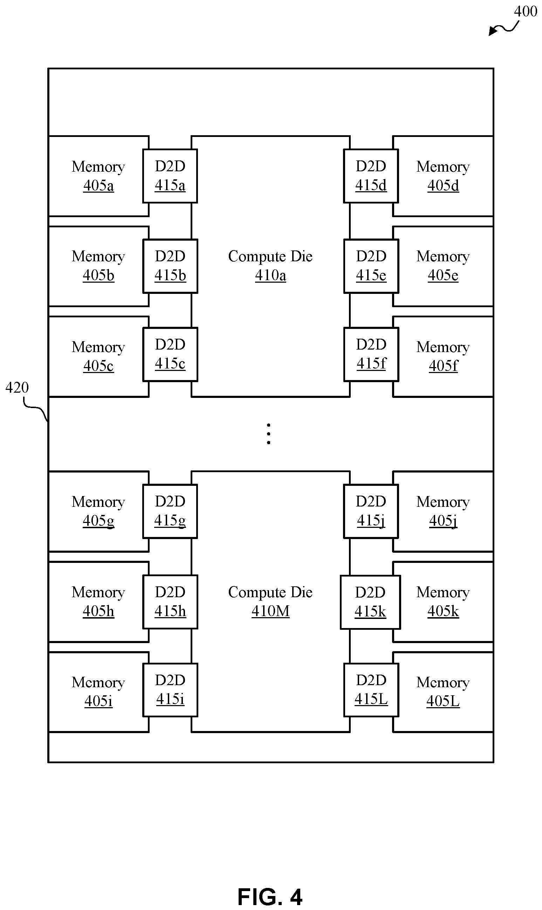

**FIG. 4** illustrates an example package 400 in accordance with one or more implementations as described herein. In some configurations, one or more aspects of package 400 may be implemented by or in conjunction with machine 105, components of machine 105, or any combination thereof. In some examples, package 400 may include a system in package (SiP). For example, package 400 may include a 2.5D SiP and/or a 3D SiP.

As shown, package 400 may include L memory dies 405 (e.g., L stacked memory dies), M compute dies 410, and L D2D interconnects 415, where L is a positive integer (e.g., 1, 2, 3, 4, 5, 6, 7, 8, 10, 12, 16, 20, 24, 30, 32, 64, etc.) and M is a positive integer (e.g., 1, 2, 3, 4, 5, 6, 7, 8, 9, 10, 12, 16, 20 etc.). A given memory die (e.g., memory dies 405) may include one or more memory core dies. In the illustrated example, package 400 may include 2 compute dies, 12 memory dies (e.g., HBM stacks), and 12 D2D interconnects. In some examples, package 400 may include interposer 420. Interposer 420 may be a layer of package 400. In some cases, L memory dies 405, M compute dies 410, and L D2D interconnects 415 may be placed on top of interposer 420.

In some examples, at least one of the L memory dies 405 may include a memory base die (e.g., base die 300) with one or more core memory dies stacked on top of the memory base die. For example, memory die 405a may include a first base die similar to base die 300, memory die 405b may include a second base die similar to base die 300, and so on. In some instances, at least one of the L memory dies 405 may include an HBM base die with one or more DRAM core memory dies stacked on top of the HBM base die. For example, memory die 405a may include a first HBM base die with one or more DRAM core memory dies stacked on top of the first HBM base die, memory die 405b may include a second HBM base die with one or more DRAM core memory dies stacked on top of the second HBM base die, and so on.

In some examples, at least one of the M compute dies 410 may include an AI accelerator (e.g., GPU, NPU, TPU, etc.). The M compute dies 410 may be configured to perform AI processing. In some cases, the M compute dies 410 may perform a first portion of the AI processing and the processing units on a base die of the L memory dies 405 may perform a second portion of the AI processing.

In some examples, a D2D interconnect may connect a compute die of package 400 to a memory die of package 400 (e.g., via interposer 420). For example, D2D interconnect 415a may connect compute die 410a to memory die 405a. Similarly, D2D interconnect 415b may connect compute die 410b to memory die 405b, and so on.

Interposer 420 may include a silicon interposer, redistribution layer (RDL) interposer, and/or an organic interposer. Interposer 420 can include an electrical interface routing between one socket or connection to another (e.g., connecting a memory die to a compute die). Interposer 420 may be implemented in conjunction with ball-grid array (BGA) packages, D2D interfaces, through silicon vias (TSVs), etc.

In some cases, at least one base die of the L memory dies 405 may include a processing unit (e.g., AI accelerator, GPU, TPU, NPU, etc.). In some cases, at least one of the processing units of the base die may include a tensor core for matrix multiplication, an arithmetic logic unit (ALU) for integer computation, a floating-point unit (FPU) for floating-point computation, and/or an accumulator to store intermediate logical or arithmetic data for multistep calculations.

One or more processing units on a first base die of the L memory dies 405 may perform machine learning and/or artificial intelligence (ML/AI) kernel operations independent of one or more processing units on a second base die of the L memory dies 405. In some cases, one or more processing units on a base die of the L memory dies 405 may perform memory-bound AI tasks while at least one of the M compute dies 410 may perform compute-bound AI tasks. For example, one or more processing units on a base die of the L memory dies 405 may perform LLM inference decode for token generation, may perform at least a portion of a kernel operation such as query key value (QKV) calculations in self-attention. In some examples, a portion of weight data (e.g., a majority of weight data) may be consumed by processing units on at least one base die of the L memory dies 405 without transferring data to compute die via interposer 420, which significantly reduces power consumption from memory I/O and communication via interposer 420.

Implementing processing units on at least one base die of the L memory dies 405 reduces data latency significantly between compute die and memory. Some data paths (e.g., 2.5D data paths) for AI compute may include the following sequence: Memory Core Die → TSV PHY → I/O PHY → Interposer → Memory Controller PHY → Memory Controller → NOC interconnect / L2 Cache → Compute Die. Based on implementing processing units on at least one base die of the L memory dies 405, this data path may be reduced. For example, based on the systems and methods described, the enhanced data path may include the following sequence: Memory Core Die → TSV PHY → Memory Controller → NOC Interconnect / L2 Cache → Compute Node, which avoids the steps of I/O PHY, Interposer, and Memory Controller PHY from the other data paths. Because the enhanced data path is kept with a given memory die (e.g., one of the L memory dies 405), the physical routing travel distance of data movement is shortened.

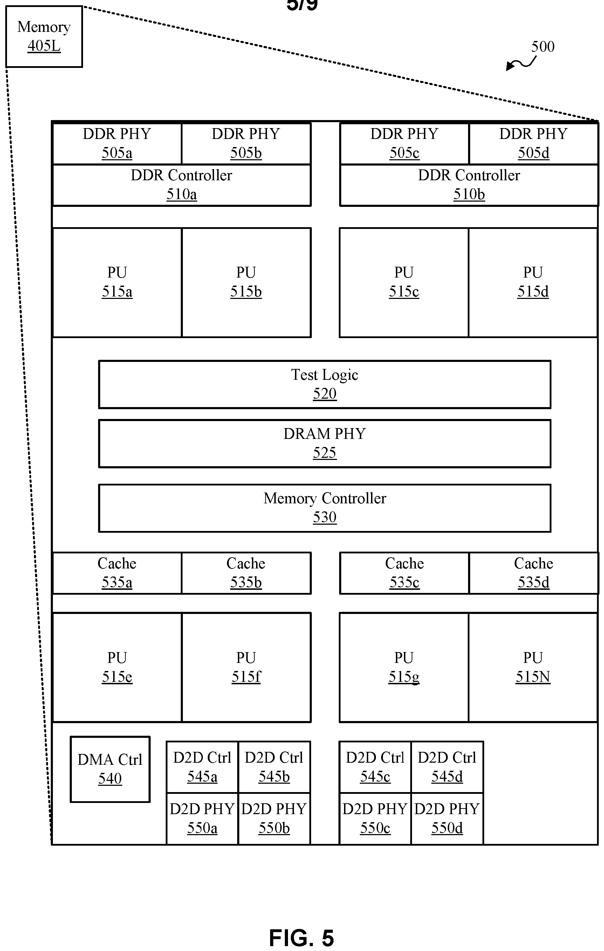

Accordingly, implementing processing units on at least one base die of the L memory dies 405 provides a memory-local compute node that can access memory with a relatively short latency and low power consumption (e.g., compared to computation by M compute dies 410). Additional details regarding a memory base die of the L memory dies 405 and processing units being incorporated on the memory base die are discussed below with reference to FIG. 5.

**FIG. 5** illustrates an example base die 500 in accordance with one or more implementations as described herein. In some configurations, one or more aspects of base die 500 may be implemented by or in conjunction with machine 105, components of machine 105, or any combination thereof. In some examples, base die 500 may be a base layer of a stacked memory module (e.g., HBM memory module, HBM chip). 2.5D and/or 3D stacking technology may be used to stack memory chips on base die 500. The memory stacked on base die 500 may be shared by one or more components of base die 500. In some cases, base die 500 may depict an example base die of one of the L memory dies 405 of FIG. 4. In some cases, base die 500 may be an example of base die 300 of FIG. 3.

As shown, base die 500 may include one or more DDR PHYs (e.g., DDR PHY 505a, DDR PHY 505b, DDR PHY 505c, DDR PHY 505d); one or more DDR controllers (e.g., DDR controller 510a, DDR controller 510b); one or more processing units (e.g., N PUs 515, where N is a positive integer, such as 1, 2, 3, 4, 5, 6, 7, 8, 9,. 10, 12, 16, 20, 24, 30, 32, 64, etc.); test logic 520, DRAM PHY 525, memory controller 530, at least one base die cache (e.g., shared memory such as cache 535a, cache 535b, cache 535c, cache 535d, etc.); at least one direct memory access (DMA) controller 540; one or more D2D controllers (e.g., D2D controller 545a, D2D controller 545b, D2D controller 545c, D2D controller 545d); and one or more D2D PHYs (e.g., D2D PHY 550a, D2D PHY 550b, D2D PHY 550c, D2D PHY 550d).

In some examples, the one or more DDR PHYs (e.g., DDR PHY 505a, etc.) may provide a physical interface for DDR memory devices associated with base die 500. In some cases, the DDR PHYs may be associated with and/or configured as one or more memory expansion ports (e.g., expansion port 305). For example, at least one of the one or more DDR PHYs may provide a physical interface to memory that is external to base die 500. For example, a memory module may include base die 500 and one or more layers of memory stacked on top of base die 500. Additionally, one or more external memory modules may connect to base die 500 via the one or more DDR PHYs. For example, at least one of the one or more DDR PHYs may connect base die 500 to off-die memory (e.g., LPDDR, GDDR, etc.).

In some examples, the one or more DDR controllers (e.g., DDR controller 510a, etc.) may be configured to control one or more aspects of base die 500 and the one or more external memory modules connected to base die 500 via the one or more DDR PHYs.

In some examples, the one or more PUs (e.g., N PUs 515) may be configured to process tasks (e.g., tasks of AI models, tasks of LLMs, etc.) on base die 500. When a compute die accesses data on base die 500, the data may move from the memory stacked on base die 500 to the compute die via memory controller 530 and the one or more D2D PHYs (e.g., D2D PHY 550a). However, moving data from base die 500 to a compute die external to base die 500 may use a relatively large amount of bandwidth and have a relatively high latency. However, by incorporating compute resources (e.g., the N PUs 515) in a given base die (e.g., base die 500), the amount of bandwidth is minimized or significantly reduced because the data is provided from memory on the base die to a PU on the base die (e.g., the storage of the data, the movement of the data, and the processing of the data remains on the base die).

Test logic 520 may be an example of test logic 310. In some examples, test logic 520 may provide testing on base die 500. In some cases, test logic 520 may include Built-In Self-Test (BIST), which may enable base die 500 to test components of base die 500 without the need for external test equipment. In some cases, test logic 520 may generate and apply test patterns to a component of base die 500, execute the tests, and analyze the results to determine whether the component is operated as expected or if testing indicates an anomaly. In some cases, one or more aspects of test logic 520 may be based on IEEE 1500, which may include a standard that defines how to test the design and/or operation of base die 500.

In some examples, DRAM PHY 525 may provide a physical interface for DRAM memory devices associated with base die 500. In some cases, DRAM PHY 525 may provide a physical interface for memory stacked on top of base die 500. For example, DRAM PHY 525 may be configured as a 3D DRAM PHY. In some cases, DRAM PHY 525 may include a TSV landing zone. The TSV landing zone may include an area of DRAM PHY 525 or an area adjacent to DRAM PHY 525 dedicated to TSV connections that connect base die 500 to layers of core memory dies stacked on top of base die 500.

In some examples, memory controller 530 may be configured to control one or more aspects of base die 500 and/or memory stacked on top of base die 500. For example, memory controller 530 may control reads and/or writes associated with memory stacked on top of base die 500. In some cases, memory controller 530 may control tasks associated with AI processing and processing performed by the N PUs 515. In some examples, memory controller 530 may include, or may be configured as an HBM controller. In some systems, an HBM controller may be located on a compute die (e.g., compute die 410a). However, based on the systems and methods described herein, an HBM controller (e.g., memory controller 530) may be located on a base die of an HBM stack (e.g., base die 500). A benefit or advantage of placing the HBM controller on the base die is that it frees up area on the compute die to add additional compute resources and/or memory/cache resources, without increasing the size of the compute die.

In some examples, base die 500 may include at least one base die cache (e.g., cache 535a, etc.). In some cases, the at least one base die cache may be shared by one or more components of base die 500. Processing of tasks by the N PUs 515 may be based on the at least one base die cache. For example, memory controller 530 may provide data from memory stacked on base die 500 to at least one base die cache. The at least one base die cache may hold the data as the N PUs 515 processes the data. For example, the at least one base die cache may hold data that is being processed by the N PUs 515. The at least one base die cache may store frequently accessed instructions and data from the memory stacked on base die 500, enabling faster retrieval and improving overall processing speed based on the speed of the at least one base die cache, but also because the at least one base die cache is located on base die 500, enabling the data being processed to remain on base die 500 and/or the memory stacked on base die 500.

In some examples, DMA controller 540 may include dedicated hardware components that enable base die 500 to transfer data directly to memory and/or from memory without intervention from a processor located off of base die 500 (e.g., without intervention from a host processor, CPU, compute die 410a, etc.). Accordingly, based on DMA controller 540 offloading data transfer tasks from an external processor, DMA controller 540 improve system performance by minimizing external processor overhead. DMA controllers may manage the data transfer process between peripherals and memory by providing the necessary addresses and control signals to access memory directly.

In some examples, DMA controller 540 may operate in conjunction with and/or may be at least partially implemented in the N PUs 515. In some cases, DMA controller 540, in conjunction with the N PUs 515, may copy data from memory external to base die 500 to memory stacked on top of base die 500 and/or to the at least one base die cache (e.g., cache 535a), where the memory external to base die 500 may include LPDDR and/or GDDR connected to base die 500 via the one or more DDR PHYs (e.g., DDR PHY 505a). In some cases, DMA controller 540, in conjunction with the N PUs 515, may copy data from memory stacked on top of base die 500 and/or to the at least one base die cache to memory external to base die 500. DMA controller 540 may handle data movement directly between the external memory and the memory of base die 500 (e.g., memory stacked on base die 500 and/or the base die cache).

In some examples, the one or more D2D controllers (e.g., D2D controller 545a, etc.) may be configured to control one or more aspects of operations associated with base die 500 and/or one or more devices external to base die 500. For example, the one or more D2D controllers may control one or more aspects (e.g., read commands, write commands, processing instructions) associated with one or more processors external to base die 500 (e.g., compute die 410a). In some cases, the one or more D2D controllers may receive the system traffic and identify if it includes a compute request (e.g., processing by the N PUs 515) or a memory request (e.g., read/write to memory stacked on base die 500). When the one or more D2D controllers identifies a memory request, then the one or more D2D controllers may route the memory request to memory controller 530. When the one or more D2D controllers identifies a compute request, then the one or more D2D controllers may route the compute request to the N PUs 515.

In some examples, the one or more D2D PHYs (e.g., D2D PHY 550a, etc.) may provide a physical interface to one or more devices external to base die 500. For example, one or more processors external to base die 500 (e.g., compute die 410a) may connect physically to base die 500 via the one or more D2D PHYs. In some cases, a compute die (e.g., compute die 410a) may communicate system traffic to base die 500 through the one or more D2D PHYs. In some cases, base die 500 may communicate system traffic to a compute die via the one or more D2D PHYs.

In some examples, base die 500 may receive a kernel operation instruction (e.g., task for AI processing, LLM processing) from a compute die (e.g., compute die 410a). In some cases, data may be copied or moved from a memory (e.g., DRAM core die) stacked on base die 500. Base die 500 may distribute the data to one or more of the N PUs 515. The one or more PUs may process the data on base die 500, avoiding the latency of having a compute die external to base die 500 process the data. For example, the N PUs 515 may perform AI processing (e.g., matrix multiplication, Softmax, etc.), thus avoiding the computational costs of transferring the data to an external compute die for processing.

In some cases, the N PUs 515 on base die 500 may enable multiple Multilayer Perceptron (MLP) layers. An MLP layer can include an artificial neural network consisting of multiple layers of neurons, including an input layer, one or more intermediate layers, an output layer, etc., where each neuron may be connected to a next layer, allowing the MLP to learn complex non-linear relationships between input and output data. In some cases, the N PUs 515 may be logically sub-divided to perform assigned tasks. For example, a first PU of the N PUs 515 may be assigned to perform physics processing (e.g., handle physics-based queries); a second PU of the N PUs 515 may be assigned to perform social processing (e.g., handle social-based queries); a third PU of the N PUs 515 may be assigned to perform history processing (e.g., handle history-based queries); a fourth PU of the N PUs 515 may be assigned to perform creative processing (e.g., handle creative writing-based queries); a fifth PU of the N PUs 515 may be assigned to perform coding processing (e.g., handle coding-based queries); a sixth PU of the N PUs 515 may be assigned to perform translation processing (e.g., handle translation -based queries), and so on.

In some cases, one or more components of base die 500 (e.g., memory controller 530, a D2D controller, and/or at least one PU) may categories a query. Additionally, or alternatively, a host may categorize a query and provide the query and category to base die 500. When a given system categorizes a query, then the query may be routed to a layer that is associated with that query category. For example, the query may be routed to at least on PU of the N PUs 515, to a compute die external to base die 500 (e.g., compute die 410a), or to an external processor and external memory (e.g., LPDDR, GDDR, etc.) connected to base die 500 via the one or more DDR PHYs (e.g., DDR PHY 505a). A computationally-intensive category may be routed to a compute die (e.g., compute die 410 with higher processing power, but with higher latency, higher power consumption). A rarely used category may be routed to the external processor and external memory (e.g., slowest processing, slowest memory). A frequently used category may be routed to one or more PUs of the N PUs 515 (e.g., lowest latency with relatively fast processing). Thus, incorporating compute resources in base dies increases system performance and significantly reduces power usage.

In some examples, tasks may be routed to base die 500 and to compute resources external to base die 500 (e.g., compute die, LPDDR, GDDR) based on the tasks being categorized as memory-bound tasks or compute-bound tasks. In the present disclosure, for example, memory bound task and compute bound task may be referred to as memory bound operations and compute bound operations, respectively. A memory bound operation can include a computational task where the overall execution time is primarily determined by the time it takes to access data from memory, where the speed of the operation may be limited by the memory bandwidth, not the processing power of a processing unit. A compute bound operation can include a computational task where the time it takes to complete is primarily determined by the speed of a processing unit, where the operation may rely heavily on complex calculations and data processing rather than waiting for memory, storage, network requests, etc. In some cases, one or more components of base die 500 (e.g., memory controller 530, a D2D controller, and/or at least one PU) may categories tasks as compute-bound and/or memory bound tasks. Additionally, or alternatively, a host may categorize tasks as compute-bound and/or memory bound tasks and communicate the categorization to base die 500.

In some examples, memory-bound tasks may be routed to base die 500 for processing (e.g., via the N PUs 515) and compute-bound tasks may be routed to the compute die for processing. Routing memory-bound kernel operations to base die 500 benefits other kernels that run on the compute die can focus on compute intensive workload.

In some cases, LLM algorithms may be memory bound operations, rather than compute bound. A memory bound operation can include a computational task where the overall execution time is primarily determined by the time it takes to access data from memory, where the speed of the operation may be limited by the memory bandwidth, not the processing power of a processing unit. A compute bound operation can include a computational task where the time it takes to complete is primarily determined by the speed of a processing unit, where the operation may rely heavily on complex calculations and data processing rather than waiting for memory, storage, network requests, etc.

The systems and methods described may be configured for memory bound operations (e.g., inference, decoding). In some cases, memory bound operations may be routed to HBM base die, while compute bound operations may be routed to one or more compute dies. Operations associated with inference, decoding, etc., may be memory-bound operations, and so may be routed to base die 500 (e.g., for processing by at least one of the N PUs 515). Operations associated with training to create AI models, LLM models, etc., may be compute-bound operations, and so may be routed to a compute die external to base die 500.

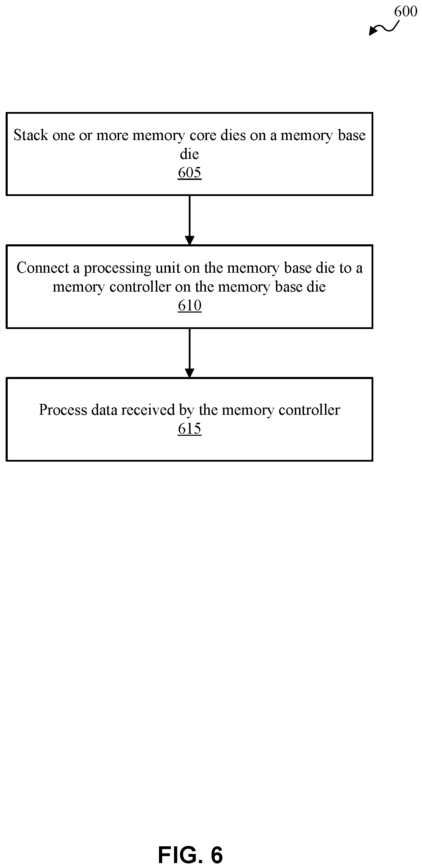

**FIG. 6** depicts a flow diagram illustrating an example method 600 associated with the disclosed systems, in accordance with example implementations described herein. Method 600 may include a method of processing in a memory of a memory base die. In some configurations, one or more aspects of method 600 may be implemented by or in conjunction with machine 105, components of machine 105, or any combination thereof. The depicted method 600 is just one implementation and one or more operations of method 600 may be rearranged, reordered, omitted, and/or otherwise modified such that other implementations are possible and contemplated.

At 605, method 600 may include stacking one or more memory dies or memory core dies on a memory base die. For example, method 600 may include a memory die fabrication system stacking one or more memory core dies on a memory base die. The memory base die may be on a package that includes a compute die.

At 610, method 600 may include connecting a processing unit on the memory base die to a memory controller on the memory base die. For example, method 600 may include a fabrication system connecting a processing unit on the memory base die to a memory controller on the memory base die.

At 615, method 600 may include processing data received by the memory controller. For example, method 600 may include the processing unit processing data received by the memory controller. The memory controller may receive the data from at least one of the one or more memory core dies.

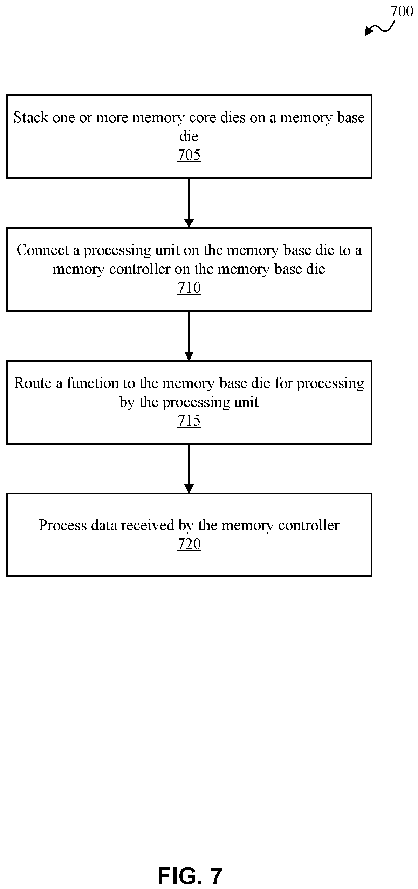

**FIG. 7** depicts a flow diagram illustrating an example method 700 associated with the disclosed systems, in accordance with example implementations described herein. Method 700 may include a method of processing in a memory of a memory base die. In some configurations, one or more aspects of method 700 may be implemented by or in conjunction with machine 105, components of machine 105, or any combination thereof. The depicted method 700 is just one implementation and one or more operations of method 700 may be rearranged, reordered, omitted, and/or otherwise modified such that other implementations are possible and contemplated.

At 705, method 700 may include stacking one or more memory core dies on a memory base die. For example, method 700 may include a memory die fabrication system stacking one or more memory core dies on a memory base die. The memory base die may be on a package that includes a compute die.

At 710, method 700 may include connecting a processing unit on the memory base die to a memory controller on the memory base die. For example, method 700 may include a fabrication system connecting a processing unit on the memory base die to a memory controller on the memory base die.

At 715, method 700 may include routing a function to the memory base die for processing by the processing unit. For example, method 700 may include routing a function to the memory base die for processing by the processing unit based on one or more aspects of the function. For instance, a first function may be routed to the memory base die for processing by at least one processing unit on the memory base die based on a determination (e.g., by a host, by machine 105, etc.) that the first function is a memory bound function. A second function may be routed to a compute die for processing by the compute die based on a determination (e.g., by a host, by machine 105, etc.) that the second function is a compute bound operation. The compute die (e.g., compute die 410a) may be connected to the memory base die (e.g., base die 300, base die 500) via a silicon interposer of the package. In some cases, a host (e.g., operating system, application, machine 105) may route the function to the memory base die. In some cases, a compute die on a package that include the memory base die may route the function to the memory base die. In some cases, a memory controller of the memory base die may route the function to the memory base die.

At 720, method 700 may include processing data received by the memory controller. For example, method 700 may include the processing unit processing data received by the memory controller. The memory controller may receive the data from at least one of the one or more memory core dies. In some cases, processing the data may be based on routing the function to the memory base die at 715.

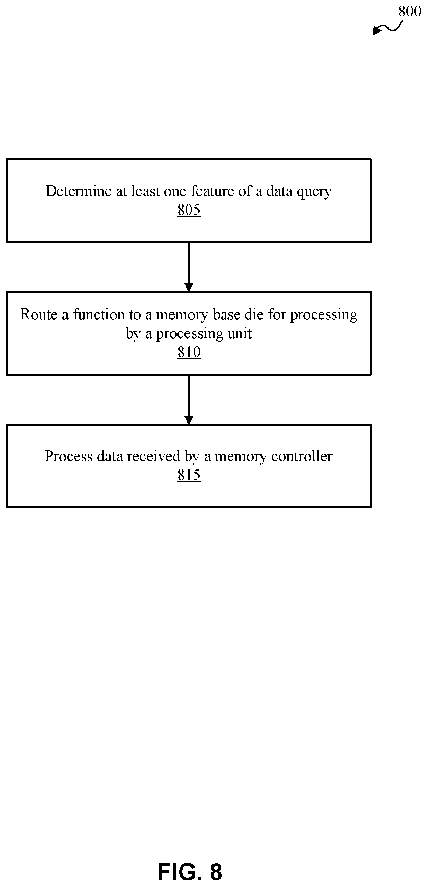

**FIG. 8** depicts a flow diagram illustrating an example method 800 associated with the disclosed systems, in accordance with example implementations described herein. Method 800 may include a method of processing in a memory of a memory base die. In some configurations, one or more aspects of method 800 may be implemented by or in conjunction with machine 105, components of machine 105, or any combination thereof. The depicted method 800 is just one implementation and one or more operations of method 800 may be rearranged, reordered, omitted, and/or otherwise modified such that other implementations are possible and contemplated.

At 805, method 800 may include determining at least one feature of a data query. For example, method 800 may include a system (e.g., machine 105, a system based on base die 300, a system based on package 400, a memory base die with one or more processing units, etc.) determining at least one feature of the data query. In some cases, the method 800 may include the system determining whether the data query comprises or is based on a compute bound function or a memory bound function.

At 810, method 800 may include routing a function to a memory base die for processing by a processing unit of the memory base die. For example, method 800 may include routing a function to the memory base die for processing by the processing unit based on determining the at least one feature of the data query. For instance, a function of the data query may be routed to a memory base die for processing by at least one processing unit on the memory base die based on a determination (e.g., by a host, by machine 105, etc.) that the function of the data query is a memory bound function. In some cases, a function may be routed to a compute die for processing by the compute die based on a determination that the function is a compute bound operation. The compute die (e.g., compute die 410a) may be connected to the memory base die (e.g., base die 300, base die 500) via a silicon interposer of the package. In some cases, a host (e.g., operating system, application, machine 105) may route the function to the memory base die. In some cases, a compute die on a package that include the memory base die may route the function to the memory base die. In some cases, a memory controller of the memory base die may route the function to the memory base die.

At 815, method 800 may include processing data received by the memory controller. For example, method 800 may include the processing unit processing data received by the memory controller. The memory controller may receive the data from at least one of the one or more memory core dies. In some cases, processing the data may be based on routing the function to the memory base die at 810.

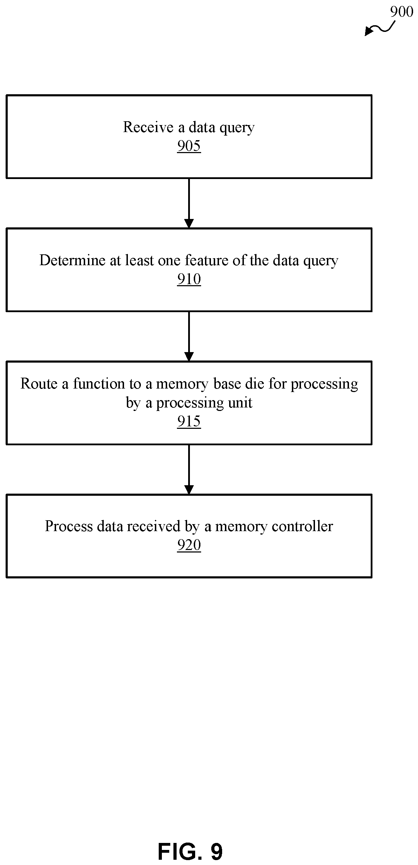

**FIG. 9** depicts a flow diagram illustrating an example method 900 associated with the disclosed systems, in accordance with example implementations described herein. Method 900 may include a method of processing in a memory of a memory base die. In some configurations, one or more aspects of method 900 may be implemented by or in conjunction with machine 105, components of machine 105, or any combination thereof. The depicted method 900 is just one implementation and one or more operations of method 900 may be rearranged, reordered, omitted, and/or otherwise modified such that other implementations are possible and contemplated.

At 905, method 900 may include receiving a data query. For example, method 900 may include a system (e.g., machine 105, a system based on base die 300, a system based on package 400, a memory base die with one or more processing units, etc.) receiving a data query associated with data processing or data accessing (e.g., AI processing, ML processing, LLM processing, etc.).

At 910, method 900 may include determining at least one feature of the data query. For example, method 900 may include the system determining at least one feature of the data query. For instance, the method 900 may include the system determining whether the data query comprises or is based on a compute bound function or a memory bound function.

At 915, method 900 may include routing a function to a memory base die for processing by a processing unit of the memory base die. For example, method 900 may include routing a function to the memory base die for processing by the processing unit based on determining the at least one feature of the data query. For instance, a function of the data query may be routed to a memory base die for processing by at least one processing unit on the memory base die based on a determination (e.g., by a host, by machine 105, etc.) that the function of the data query is a memory bound function. In some cases, a function may be routed to a compute die for processing by the compute die based on a determination that the function is a compute bound operation. The compute die (e.g., compute die 410a) may be connected to the memory base die (e.g., base die 300, base die 500) via a silicon interposer of the package. In some cases, a host (e.g., operating system, application, machine 105) may route the function to the memory base die. In some cases, a compute die on a package that include the memory base die may route the function to the memory base die. In some cases, a memory controller of the memory base die may route the function to the memory base die.

At 920, method 900 may include processing data received by the memory controller. For example, method 900 may include the processing unit processing data received by the memory controller. The memory controller may receive the data from at least one of the one or more memory core dies. In some cases, processing the data may be based on routing the function to the memory base die at 915.

In the examples described herein, the configurations and operations are example configurations and operations, and may involve various additional configurations and operations not explicitly illustrated. In some examples, one or more aspects of the illustrated configurations and/or operations may be omitted. In some embodiments, one or more of the operations may be performed by components other than those illustrated herein. Additionally, or alternatively, the sequential and/or temporal order of the operations may be varied.

Certain embodiments may be implemented in one or a combination of hardware, firmware, and software. Other embodiments may be implemented as instructions stored on a computer-readable storage device, which may be read and executed by at least one processor to perform the operations described herein. A computer-readable storage device may include any non-transitory memory mechanism for storing information in a form readable by a machine (e.g., a computer). For example, a computer-readable storage device may include read-only memory (ROM), random-access memory (RAM), magnetic disk storage media, optical storage media, flash-memory devices, and other storage devices and media.

The word "exemplary" is used herein to mean "serving as an example, instance, or illustration." Any embodiment described herein as "exemplary" is not necessarily to be construed as preferred or advantageous over other embodiments. The terms "computing device," "user device," "communication station," "station," "handheld device," "mobile device," "wireless device" and "user equipment" (UE) as used herein refers to a wired and/or wireless communication device such as a switch, router, network interface controller, cellular telephone, smartphone, tablet, netbook, wireless terminal, laptop computer, a femtocell, High Data Rate (HDR) subscriber station, access point, printer, point of sale device, access terminal, or other personal communication system (PCS) device. The device may be wireless, wired, mobile, and/or stationary.

As used within this document, the term "communicate" is intended to include transmitting, or receiving, or both transmitting and receiving. Similarly, the bidirectional exchange of data between two devices (both devices transmit and receive during the exchange) may be described as 'communicating', when only the functionality of one of those devices is being claimed. The term "communicating" as used herein with respect to wired and/or wireless communication signals includes transmitting the wired and/or wireless communication signals and/or receiving the wired and/or wireless communication signals. For example, a communication unit, which is capable of communicating wired and/or wireless communication signals, may include a wired/wireless transmitter to transmit communication signals to at least one other communication unit, and/or a wired/wireless communication receiver to receive the communication signal from at least one other communication unit.

Some embodiments may be used in conjunction with various devices and systems, for example, a Personal Computer (PC), a desktop computer, a mobile computer, a laptop computer, a notebook computer, a tablet computer, a server computer, a handheld computer, a handheld device, a Personal Digital Assistant (PDA) device, a handheld PDA device, an on-board device, an off-board device, a hybrid device, a vehicular device, a non-vehicular device, a mobile or portable device, a consumer device, a non-mobile or non-portable device, a wireless communication station, a wireless communication device, a wireless Access Point (AP), a wired or wireless router, a wired or wireless modem, a video device, an audio device, an audio-video (A/V) device, a wired or wireless network, a wireless area network, a Wireless Video Area Network (WVAN), a Local Area Network (LAN), a Wireless LAN (WLAN), a Personal Area Network (PAN), a Wireless PAN (WPAN), and the like.

Some embodiments may be used in conjunction with one way and/or two-way radio communication systems, cellular radio-telephone communication systems, a mobile phone, a cellular telephone, a wireless telephone, a Personal Communication Systems (PCS) device, a PDA device which incorporates a wireless communication device, a mobile or portable Global Positioning System (GPS) device, a device which incorporates a GPS receiver or transceiver or chip, a device which incorporates an RFID element or chip, a Multiple Input Multiple Output (MIMO) transceiver or device, a Single Input Multiple Output (SIMO) transceiver or device, a Multiple Input Single Output (MISO) transceiver or device, a device having one or more internal antennas and/or external antennas, Digital Video Broadcast (DVB) devices or systems, multi-standard radio devices or systems, a wired or wireless handheld device, e.g., a Smartphone, a Wireless Application Protocol (WAP) device, or the like.

Some embodiments may be used in conjunction with one or more types of wireless communication signals and/or systems following one or more wireless communication protocols, for example, Radio Frequency (RF), Infrared (IR), Frequency-Division Multiplexing (FDM), Orthogonal FDM (OFDM), Time-Division Multiplexing (TDM), Time-Division Multiple Access (TDMA), Extended TDMA (E-TDMA), General Packet Radio Service (GPRS), extended GPRS, Code-Division Multiple Access (CDMA), Wideband CDMA (WCDMA), CDMA 2000, single-carrier CDMA, multi-carrier CDMA, Multi-Carrier Modulation (MDM), Discrete Multi-Tone (DMT), Bluetooth^{™} Global Positioning System (GPS), Wi-Fi, Wi-Max, ZigBee^{™}, Ultra-Wideband (UWB), Global System for Mobile communication (GSM), 2G, 2.5G, 3G, 3.5G, 4G, Fifth Generation (5G) mobile networks, 3GPP, Long Term Evolution (LTE), LTE advanced, Enhanced Data rates for GSM Evolution (EDGE), or the like. Other embodiments may be used in various other devices, systems, and/or networks.

Although an example processing system has been described above, embodiments of the subject matter and the functional operations described herein can be implemented in other types of digital electronic circuitry, or in computer software, firmware, or hardware, including the structures disclosed in this specification and their structural equivalents, or in combinations of one or more of them.

Embodiments of the subject matter and the operations described herein can be implemented in digital electronic circuitry, or in computer software, firmware, or hardware, including the structures disclosed in this specification and their structural equivalents, or in combinations of one or more of them. Embodiments of the subject matter described herein can be implemented as one or more computer programs, i.e., one or more components of computer program instructions, encoded on computer storage medium for execution by, or to control the operation of, information/data processing apparatus. Alternatively, or in addition, the program instructions can be encoded on an artificially-generated propagated signal, for example a machine-generated electrical, optical, or electromagnetic signal, which is generated to encode information/data for transmission to suitable receiver apparatus for execution by an information/data processing apparatus. A computer storage medium can be, or be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially-generated propagated signal. The computer storage medium can also be, or be included in, one or more separate physical components or media (for example multiple CDs, disks, or other storage devices).

The operations described herein can be implemented as operations performed by an information/data processing apparatus on information/data stored on one or more computer-readable storage devices or received from other sources.

The term "data processing apparatus" encompasses all kinds of apparatus, devices, and machines for processing data, including by way of example a programmable processor, a computer, a system on a chip, or multiple ones, or combinations, of the foregoing. The apparatus can include special purpose logic circuitry, for example an FPGA (field programmable gate array) or an ASIC (application-specific integrated circuit). The apparatus can also include, in addition to hardware, code that creates an execution environment for the computer program in question, for example code that constitutes processor firmware, a protocol stack, a database management system, an operating system, a cross-platform runtime environment, a virtual machine, or a combination of one or more of them. The apparatus and execution environment can realize various different computing model infrastructures, such as web services, distributed computing and grid computing infrastructures.

A computer program (also known as a program, software, software application, script, or code) can be written in any form of programming language, including compiled or interpreted languages, declarative or procedural languages, and it can be deployed in any form, including as a stand-alone program or as a component, component, subroutine, object, or other unit suitable for use in a computing environment. A computer program may, but need not, correspond to a file in a file system. A program can be stored in a portion of a file that holds other programs or information/data (for example one or more scripts stored in a markup language document), in a single file dedicated to the program in question, or in multiple coordinated files (for example files that store one or more components, sub-programs, or portions of code). A computer program can be deployed to be executed on one computer or on multiple computers that are located at one site or distributed across multiple sites and interconnected by a communication network.

The processes and logic flows described herein can be performed by one or more programmable processors executing one or more computer programs to perform actions by operating on input information/data and generating output. Processors suitable for the execution of a computer program include, by way of example, both general and special purpose microprocessors, and any one or more processors of any kind of digital computer. Generally, a processor will receive instructions and information/data from a read-only memory or a random access memory or both. The essential elements of a computer are a processor for performing actions in accordance with instructions and one or more memory devices for storing instructions and data. Generally, a computer will also include, or be operatively coupled to receive information/data from or transfer information/data to, or both, one or more mass storage devices for storing data, for example magnetic, magneto-optical disks, or optical disks. However, a computer need not have such devices. Devices suitable for storing computer program instructions and information/data include all forms of non-volatile memory, media and memory devices, including by way of example semiconductor memory devices, for example EPROM, EEPROM, and flash memory devices; magnetic disks, for example internal hard disks or removable disks; magneto-optical disks; and CD-ROM and DVD-ROM disks. The processor and the memory can be supplemented by, or incorporated in, special purpose logic circuitry.

To provide for interaction with a user, embodiments of the subject matter described herein can be implemented on a computer having a display device, for example a CRT (cathode ray tube) or LCD (liquid crystal display) monitor, for displaying information/data to the user and a keyboard and a pointing device, for example a mouse or a trackball, by which the user can provide input to the computer. Other kinds of devices can be used to provide for interaction with a user as well; for example, feedback provided to the user can be any form of sensory feedback, for example visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's client device in response to requests received from the web browser.

Embodiments of the subject matter described herein can be implemented in a computing system that includes a back-end component, for example as an information/data server, or that includes a middleware component, for example an application server, or that includes a front-end component, for example a client computer having a graphical user interface or a web browser through which a user can interact with an embodiment of the subject matter described herein, or any combination of one or more such back-end, middleware, or front-end components. The components of the system can be interconnected by any form or medium of digital information/data communication, for example a communication network. Examples of communication networks include a local area network ("LAN") and a wide area network ("WAN"), an inter-network (for example the Internet), and peer-to-peer networks (for example ad hoc peer-to-peer networks).

The computing system can include clients and servers. A client and server are generally remote from each other and typically interact through a communication network. The relationship of client and server arises by virtue of computer programs running on the respective computers and having a client-server relationship to each other. In some embodiments, a server transmits information/data (for example an HTML page) to a client device (for example for purposes of displaying information/data to and receiving user input from a user interacting with the client device). Information/data generated at the client device (for example a result of the user interaction) can be received from the client device at the server.

While this specification contains many specific embodiment details, these should not be construed as limitations on the scope of any embodiment or of what may be claimed, but rather as descriptions of features specific to particular embodiments. Certain features that are described herein in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain embodiments, multitasking and parallel processing may be advantageous.

Many modifications and other examples as set forth herein will come to mind to one skilled in the art to which these embodiments pertain having the benefit of the teachings presented in the foregoing descriptions and the associated drawings. Therefore, it is to be understood that the embodiments are not to be limited to the specific embodiments disclosed and that modifications and other embodiments are intended to be included within the scope of the appended claims. Although specific terms are employed herein, they are used in a generic and descriptive sense only and not for purposes of limitation.

## Claims

1. A method of processing in a memory, the method comprising:
determining at least one feature of a data query;
routing, based on the at least one feature of the data query, a first function of the data query to a memory base die for processing by a processing unit on the memory base die; and
processing, via the processing unit, data that a memory controller on the memory base die receives from at least one of one or more memory dies stacked on top of the memory base die.

2. The method of claim 1, further comprising:
routing the first function to the memory base die for processing by the processing unit on the memory base die based on a determination that the first function is a memory bound function, and/or
routing a second function of the data query to a compute die for processing by the compute die based on a determination that the second function is a compute bound operation, wherein the compute die is connected to the memory base die via a silicon interposer of a system in package that includes the compute die and the memory base die.

3. The method of claim 1 or 2, wherein the memory base die comprises a memory expansion port connected to at least one of a low power double data rate memory or a graphics double data rate memory external to the memory base die.

4. The method of claim 3, further comprising at least one of:
routing, via the memory controller, functions of a first category to the memory base die for processing by the processing unit on the memory base die,
routing, via the memory controller, functions of a second category to a compute die for processing by the compute die, or
routing, via the memory controller, functions of a third category to at least one of the low power double data rate memory or the graphics double data rate memory external to the memory base die.

5. The method of any one of claims 1 to 4, further comprising:
transferring, by way of a through silicon via, the data from the one or more memory dies to a physical layer interface of the memory base die;
transferring the data from the physical layer interface to the memory controller of the memory base die; and
transferring the data from the memory controller to a shared memory on the memory base die, wherein the shared memory holds the data for processing of the data by the processing unit.

6. The method of any one of claims 1 to 5, wherein the processing unit comprises at least one of:
a tensor core configured for matrix multiplication, or
an accumulator configured for accumulating intermediate calculations.

7. The method of any one of claims 1 to 6, wherein:
the memory controller connects to the processing unit via a network on chip, NOC, interconnect bus, and
the memory controller connects to a dynamic random-access memory, DRAM, physical layer on the memory base die via a double data rate, DDR, physical layer interface of the memory base die.

8. The method of claim 7, wherein:
a system bus interface connects to a die-to-die interface of the memory base die, and
the processing unit connects to the system bus interface via the NOC interconnect bus, the system bus interface converting data in a die-to-die flit format to a network packet format.

9. The method of any one of claims 1 to 8, wherein:
the memory controller is communicatively coupled to the processing unit, and
a second memory controller on the memory base die is communicatively coupled to a second processing unit on the memory base die.

10. A system comprising:
a memory base die, the memory base die comprising:
a memory controller;
one or more memory dies stacked on top of the memory base die; and
a processing unit configured to process data that the memory controller receives from at least one of the one or more memory dies, the data being routed to the processing unit based on at least one feature of a data query associated with the data;
an interconnect that connects the memory controller to the one or more memory dies stacked on the memory base die and to multiple processing units that include the processing unit; and
a die-to-die interface that connects the memory base die to a compute die of a system in package.

11. The system of claim 10, wherein a function of the data query is routed to the memory base die for processing by the processing unit based on a determination that the function is a memory bound function, and/or
wherein a function of a second data query is routed to the compute die for processing by the compute die based on a determination that the second function is a compute bound operation, wherein the compute die is connected to the memory base die via a silicon interposer of the system in package.

12. The system of claim 10 or 11, wherein the system in package includes multiple memory base dies connected to the compute die, the multiple memory base dies including the memory base die.

13. The system of any one of claims 10 to 12,
wherein the memory base die comprises a system bus interface that connects the interconnect to the die-to-die interface of the memory base die, and the system bus interface maps a data format used by the interconnect to a data format used by the die-to-die interface, and/or
wherein the memory base die comprises a shared memory to share data between a first processing unit and a second processing unit of the multiple processing units.

14. The system of any one of claims 10 to 13, wherein the memory base die comprises a memory expansion port connected to at least one of a low power double data rate memory or a graphics double data rate memory external to the memory base die.

15. A non-transitory computer-readable medium storing code that comprises instructions executable by a processor of a device to perform the method according to any one of claims 1 to 9.

## Amended claims

### Amended claims in accordance with Rule 137(2) EPC.

1. A method (800) of processing in a memory, the method (800) comprising:
determining at least one feature of a data query;
routing, based on the at least one feature of the data query, a first function of the data query to a memory base die (300) for processing by a processing unit (330) on the memory base die (300); and
processing, via the processing unit (330), data that a memory controller (320) on the memory base die (300) receives from at least one of one or more memory dies stacked on top of the memory base die (300),
further comprising:
routing the first function to the memory base die (300) for processing by the processing unit (330) on the memory base die (300) based on a determination that the first function is a memory bound operation, the memory bound operation comprising a computational task wherein an overall execution time of the computational task is determined by a time it takes to access data from the memory, and wherein a speed of the memory bound operation is limited by a memory bandwidth, and/or
routing a second function of the data query to a compute die (410) for processing by the compute die (410) based on a determination that the second function is a compute bound operation, the compute bound operation comprising a computational task wherein a time it takes to complete the computational task is determined by a speed of a processing unit, and wherein the compute bound operation relies on calculations and data processing, wherein the compute die (410) is connected to the memory base die (300) via a silicon interposer of a system in package (400) that includes the compute die (410) and the memory base die (300).

2. The method (800) of claim 1, wherein the memory base die (300) comprises a memory expansion port connected to at least one of a low power double data rate memory or a graphics double data rate memory external to the memory base die (300).

3. The method (800) of claim 2, further comprising at least one of:
routing, via the memory controller (320), functions of a first category to the memory base die (300) for processing by the processing unit (330) on the memory base die (300),
routing, via the memory controller (320), functions of a second category to a compute die (410) for processing by the compute die (410), or
routing, via the memory controller (320), functions of a third category to at least one of the low power double data rate memory or the graphics double data rate memory external to the memory base die (300).

4. The method (800) of any one of claims 1 to 3, further comprising:
transferring, by way of a through silicon via, the data from the one or more memory dies to a physical layer interface of the memory base die (300);
transferring the data from the physical layer interface to the memory controller (320) of the memory base die (300); and
transferring the data from the memory controller (320) to a shared memory on the memory base die (300), wherein the shared memory holds the data for processing of the data by the processing unit (330).

5. The method (800) of any one of claims 1 to 4, wherein the processing unit (330) comprises at least one of:
a tensor core configured for matrix multiplication, or
an accumulator configured for accumulating intermediate calculations.

6. The method (800) of any one of claims 1 to 5, wherein:
the memory controller (320) connects to the processing unit (330) via a network on chip, NOC, interconnect bus, and
the memory controller (320) connects to a dynamic random-access memory, DRAM, physical layer on the memory base die (300) via a double data rate, DDR, physical layer interface of the memory base die (300).

7. The method (800) of claim 6, wherein:
a system bus interface (335) connects to a die-to-die interface of the memory base die (300), and
the processing unit (330) connects to the system bus interface (335) via the NOC interconnect bus, the system bus interface (335) converting data in a die-to-die flit format used by the die-to-die interface to network packet data in a format used by the NOC inerconnect bus.

8. The method (800) of any one of claims 1 to 7, wherein:
the memory controller (320) is communicatively coupled to the processing unit (330), and
a second memory controller on the memory base die (300) is communicatively coupled to a second processing unit on the memory base die (300).

9. A system (100) comprising:
a memory base die (300); and
one or more memory dies stacked on top of the memory base die (300); the memory base die (300) comprising:
a memory controller (320); and
a processing unit (330) configured to process data that the memory controller (320) receives from at least one of the one or more memory dies, the data being routed to the processing unit (330) based on at least one feature of a data query associated with the data;
an interconnect (325) that connects the memory controller (320) to the one or more memory dies stacked on the memory base die (300) and to multiple processing units that include the processing unit (330); and
a die-to-die interface connectable to a compute die (410), the die-to die interface being configured to connect the memory base die (300) to the compute die (410),
wherein a function of the data query is routed to the memory base die (300) for processing by the processing unit (330) based on a determination that the function is a memory bound operation, the memory bound operation comprising a computational task wherein an overall execution time of the computational task is determined by a time it takes to access data from a memory, and wherein a speed of the memory bound operation is limited by a memory bandwidth, and/or
wherein a function of a second data query is routed to the compute die (410) for processing by the compute die (410) based on a determination that the second function is a compute bound operation, the compute bound operation comprising a computational task wherein a time it takes to complete the computational task is determined by a speed of the processing unit (330), and wherein the compute bound operation relies on calculations and data processing, wherein the compute die (410) is connected to the memory base die (300) via a silicon interposer of the system in package (400).

10. The system (100) of claim 9, wherein the system in package (400) includes multiple memory base dies (300) connected to the compute die (410), the multiple memory base dies (300) including the memory base die (300).

11. The system (100) of claim 9 or 10,
wherein the memory base die (300) comprises a system bus interface (335) that connects the interconnect (325) to the die-to-die interface of the memory base die (300), and the system bus interface (335) maps a data format used by the interconnect (325) to a data format used by the die-to-die interface, and/or
wherein the memory base die (300) comprises a shared memory to share data between a first processing unit and a second processing unit of the multiple processing units.

12. The system (100) of any one of claims 9 to 11, wherein the memory base die (300) comprises a memory expansion port connectable to at least one of a low power double data rate memory or a graphics double data rate memory external to the memory base die (300).

13. A non-transitory computer-readable medium storing code that comprises instructions which, when executed by a processor of a device, cause the processor to perform the method (800) according to any one of claims 1 to 8.
